# EUROPEAN PATENT APPLICATION

(11) **EP 1 553 694 A1**
(43) Date of publication of application: **13.07.2005**
(21) Application number: 04257337.8
(22) Date of filing: 25.11.2004
(51) Int. Cl.: H03C 3/00, H04L 27/10

(54) **Modulation and transmission methods to provide a wireless link and transmitter circuit for providing a wireless link**

(30) Priority: 12.01.2004 US 754549
(71) Applicant: LUCENT TECHNOLOGIES INC., Murray Hill, New Jersey 07974-0636 (US)
(72) Inventor: Baras, Torben, 38112 Braunschweig (DE); Metz, Carsten, New Jersey, 07928 (US)
(74) Representative: Watts, Christopher Malcolm Kelway, Dr.

(57) **Abstract**

A modulation method, transmission method, and transmitter circuit are described which may enable realization of a wireless link for ultra-high transmission rates in the downlink to users. In a method of modulating an input signal to obtain a desired intermediate signal, the intermediate signal is to be processed for transmission over a wireless link at a carrier frequency within a desired frequency band. The processing may include subjecting the intermediate signal to a frequency multiplier operation that exhibits an ambiguous transfer function. In the modulation method, an input signal is provided, and a set of signal states applicable to the desired intermediate signal are generated so that a signal output from the frequency multiplier operation has a substantially non-ambiguous relation to the desired intermediate signal. The input signal may thus be modulated according to I and Q baseband signals to obtain the desired intermediate signal with the generated set of signal states.

## Description

### BACKGROUND OF THE INVENTION

### Field of the Invention

The present invention relates generally to wireless communication links.

### Related Art

On October 16, 2003, the Federal Communications Commission (FCC) adopted service rules for commercial use of a previously empty swath of spectrum, in an effort to promote the development of an additional competitive broadband deployment platform. This domain lies in the frequency bands from 71 to 76 gigahertz (GHz), 81 to 86 GHz and 92 to 95 GHz -- collectively known as the 'E-Band', the highest frequencies ever licensed by the FCC. This high-frequency swath of spectrum may eventually become essential to ultra-high-speed data communication to provide a broad range of innovative products and services, including high-speed, point-to-point (PTP) wireless local area networks and operations, and broadband internet access, for example.

Broadcast television and radio, mobile phones, WiFi computer networks and other familiar wireless applications operate from under 1 GHz to 5 GHz. These frequencies use radio wavelengths that are several feet long, while E-Band signals are three to five millimeters long -- about an eighth of an inch. These small millimeter waves make E-Band a challenging band to use. Transmission range may be severely limited, and the signals can sometimes be blocked by rain, fog or even high humidity. Yet E-Band's small waves can transmit huge volumes of data -- about 1.25 gigabits per second today and possibly 10 gigabits per second in a few years. That's 1,000 to 10,000 times faster than today's high-speed home cable modem and Digital Subscriber Line (DSL) service.

For example, an uncompressed two-hour DVD-quality movie would take about nine hours to download through a cable modem running at 1 megabit per second, but would take only about 30 seconds through a 1-gigabit network operating within the E-band, and just four seconds through a 10-gigabit connection. It's also much easier to focus E-Band radio waves into a very narrow 'pencil beam' that can be aimed from one point to another, without causing interference at nearby E-Band receivers.

Because the pencil beams stay tightly focused over such short distances, the FCC is allowing a unique form of licensing. Instead of applying for rights to cover an entire region, such as an AM radio station with a license to broadcast over a large metropolitan area, E-Band licenses will be granted from one geographic point to another. The broadcasting paths will be allowed to cross each other, because the beams won't cause interference to neighboring receivers, so almost no one will be denied an E-Band request.

All of this may explain a first possible application for E-Band: extending 1-gigabit fiber-optic networks from one building to another wirelessly over an E-band link, instead of employing fiber-optic wiring (e.g., an E1/T1 backhaul or fiber optic cable). Fiber-optic cable is cheap. Stringing the cable on poles or burying it in trenches isn't, running from about $100,000 to $500,000 a mile.

For example, two E-Band antenna dishes, no more than four feet in diameter, aimed at each other from a distance of up to a mile, may be able to establish a 1-gigabit link for a fraction of the cost for poles or trenches. In a year or two, it has been estimated that such an E-Band link may cost only about $20,000 to produce, as suggested in an October 27, 2003 article by Mike Langberg of MercuryNews.com entitled "FCC move opening E-band could be telecom gold mine".

However, even at these reduced estimated costs to produce the circuitry, components and equipment to support the E-band link, such costs do not provide a viable option for home users desiring E-band services. Accordingly, it may be desirable to develop systems, processes, circuitry and/or components which may help enable an E-Band wireless link to become a realistic alternative to fiber-optic wiring, so costs may be reduced sufficiently enough to deliver E-band services such as 1-gigabit Internet access, for example, to the small business or home user.

### SUMMARY OF THE INVENTION

The exemplary embodiments of the present invention provide a modulation method, transmission method, and transmitter circuit that may enable realization of a wireless link alternative to a fiber-optic T1/E1 backhaul for delivering services at ultra-high transmission rates in the downlink to users.

An exemplary embodiment of the present invention is directed to a method of modulating an input signal to obtain a desired intermediate signal that is to be subject to processing for transmission over a wireless link at a carrier frequency within a desired frequency band. The processing may include subjecting the desired intermediate signal to a frequency multiplier operation that exhibits an ambiguous transfer function. In the method, an input signal is provided, and a set of signal states applicable to the desired intermediate signal may be generated so that a signal resulting from the processing, and which is to be transmitted at the carrier frequency, has a substantially non-ambiguous relation to the desired intermediate signal. The input signal may be modulated according to I and Q baseband signals to obtain the desired intermediate signal with the generated set of signal states.

Another exemplary embodiment of the present invention is directed to a transmitter circuit and method for transmitting data over a wireless link at a carrier frequency within a desired frequency band. A frequency synthesizer may input a sinusoidal signal for modulation, and a digital processor may generate a set of signal states applicable to a desired modulated baseband signal. The sinusoidal signal may be modulated in an I/Q modulator according to I and Q baseband signals to obtain the desired modulated baseband signal with the generated set of signal states. A mixer may upconvert the modulated baseband signal to an intermediate frequency (IF) signal, which may then be filtered to remove out-of-band components, and amplified to a desired signal level, providing an input signal to a frequency multiplier. Although the frequency multiplier operation performed by the frequency multiplier is characterized by an ambiguous transfer function, an output signal is produced which has a substantially non-ambiguous relation to the input signal, and hence to the desired modulated baseband signal. The output signal may be transmitted at the carrier frequency within the desired frequency band over the wireless link.

### BRIEF DESCRIPTION OF THE DRAWINGS

Exemplary embodiments of the present invention will become more fully understood from the detailed description given herein below and the accompanying drawings, wherein like elements are represented by like reference numerals, which are given by way of illustration only and thus are not limitative of the exemplary embodiments of the present invention and wherein:

FIG. 1 is a block diagram of an exemplary transmitter circuit for a transceiver capable of providing a wireless link in accordance with an exemplary embodiment of the present invention.

FIG. 2 is a phase diagram for illustrating a method of modulating an input signal to obtain a desired intermediate signal that may be subject to a frequency multiplier operation within the transmitter circuit of FIG. 1.

### DETAILED DESCRIPTION OF THE EXEMPLARY EMBODIMENTS

Although the following description relates to a wireless point-to-point or point-to-multipoint link envisioned as an alternative to a fiber optic link such as a T1/E1 in wireless communication networks or systems based on as 802.11, CDMA (3G-1 x EV-DO, 3G-1x EV-DV) and/or UMTS technologies, and will be described in this exemplary context, it should be noted that the exemplary embodiments shown and described herein are meant to be illustrative only and not limiting in any way. As such, various modifications will be apparent to those skilled in the art for application to wireless communication systems or networks based on technologies other than the above which may be in various stages of development and intended for future replacement of, or use with, the above networks or systems.

The exemplary embodiments of the present invention envision modifying an existing multifunctional transceiver, such as a multifunctional W-band transceiver used in the automotive radar market that operates at 76-77 GHz, in order to provide E-band wireless links which may supplant E1/T1 backhaul links to provide data to downlink users at data rates from at least 10 Megabits per second (Mbps) to rates perhaps exceeding 10 Gigabits per second (Gbps). Accordingly, one motivation is to utilize existing off the shelf components, such as circuit components from these automotive radar type systems or applications, in order to realize a cost effective E-band wireless link.

The modified multifunctional transceiver may utilize the existing receiver structure from the aforementioned W-band transceiver, but may be configured with a modified transmitter circuit. The modified transmitter circuit may thus be produced as part of a proposed E-band transceiver system that may be manufactured at substantially reduced costs than estimated, perhaps on the order of about $700, for example.

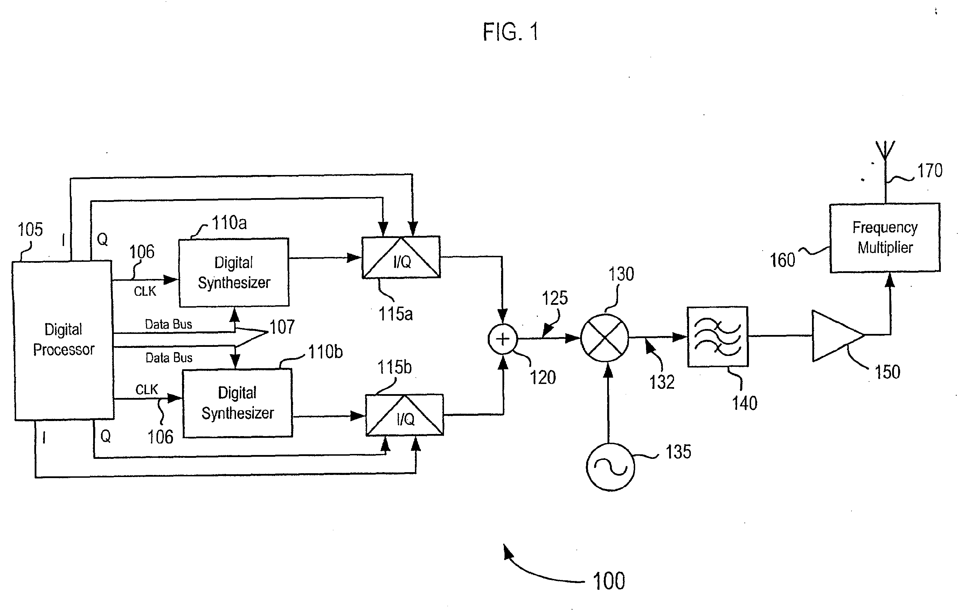

FIG. 1 is a block diagram of an exemplary transmitter circuit for a transceiver capable of providing a wireless link in accordance with an exemplary embodiment of the present invention. For exemplary purpose only, generated signals are described below at exemplary frequencies and powers, it being understood that such signals can be obtained at different frequencies and powers consistent with the knowledge of those skilled in the art.

Referring to FIG. 1, transmitter circuit 100 may include a digital processor 105 which can perform various digital data processes. Digital processor 105 may be configured as a digital signal processor, digital logic, as one or more application specific integrated circuits (ASIC) or as any other processor of digital data that is known to those skilled in the art, for example.

For exemplary purposes only, FIG. 1 will be explained in terms of modulating a base band signal so as to output a transmit signal at a carrier frequency within the E-band, thus providing a wireless link to provide data to downlink users at data rates of at least 10 Megabits per second (Mbps) to rates perhaps exceeding 10 Gigabits per second (Gbps). In this example, the carrier frequency may be a signal frequency of 76.5 GHz at a exemplary power of 18 dBm, it being understood that the exemplary embodiments envision generation of transmit signals at other carrier frequencies within the E-band and perhaps at even higher frequencies. Since direct modulation of the 76.5 GHz carrier frequency can only be performed with substantially high conversion loss (which barely can be compensated for), FIG. 1 illustrates a modified super heterodyne approach, where two parallel modular chains provide a modulated base band signal 125 (also referred to as a desired intermediate signal) as a result of summing the modulated base band signals from the two chains at summer 120.

Digital processor 105 generates a digital clock signal 106 and a serial data bus signal 107 to each of a pair of modulator chains. The digital clock signal 106 is used as a frequency standard for a digital frequency synthesizer 110a/110b in each chain, and to set a clock for data in the chip encompassing the transmitter circuit components, for example. The serial data bus signal 107 may be used to program a corresponding digital frequency synthesizer 110a or 110b so as to set a frequency output from the frequency synthesizer 110a or 110b to a desired frequency. The digital frequency synthesizer 110a or 110b may be on off the shelf component such as a model ADF4213 frequency synthesizer from Analog Devices, Inc., for example. Each frequency synthesizer 110a or 110b thus outputs a sinusoidal signal at the desired frequency.

Each chain includes the aforementioned digital synthesizer 110a or 110b and an I/Q modulator 115a or 115B. Digital processor 105, in addition to inputting digital clock signals and serial data bus signals to each digital synthesizer 105A/105B also provides I and Q baseband modulation signals to each of the I/Q modulators 115a and 115b. It should be understood that transmitter circuit 105 may be configured with multiple digital processors 105 (such as two or more ASICs, digital logic components, etc.) to separately generate the digital clock 106, data bus signal 107 and baseband I and Q signals. The I/Q modulator 115a or 115b may be an off the shelf device such as the model T0790 700-2700MHz Direct Quadrature Modulator made by ATMEL, for example.

The modulated base band signals output of I/Q modulators 115a and 115b are summed at summer 120 to provide a modulated base band signal (desired intermediate signal). The modulated base band signal in this example may be at a frequency of 2.1 MHz and a power 7dBm, for example, it being understood that this is only an exemplary base band signal and other frequencies and powers may be used.

The modulated base band signal 125 may be upconverted in a mixer 130 to an intermediate frequency IF 132. In this exemplary embodiment, the IF signal 132 output of mixer 130 may be at a frequency of 38.25 GHz and power of -14 dBm, for example, and may be obtained by mixing a local oscillation signal from local oscillator 135 at 36.15 GHz with the 2.1 MHz modulated base band signal 125, for CHV2240 from United Monolithic Semiconductors (UMS), S.A.S. The mixer 130 may be an off the shelf component such as the model TLCMR 2981, made by TLC Precision Wafer Technologies, Inc., for example.

The IF signal 132 output from mixer 130 may be input to a suitable band pass filter (BPF) 140, so that out of band signal components may be suppressed. In this example, the band pass filter may be at a bandpass frequency of 38.25GHz and bandwidth (Δf = 2 GHz), so as to output a filtered IF signal at. Such a BPF 140 may be realized in printed circuit technology, for example. Optionally, a low pass filter may be placed between summer 120 and mixer 130, for example, or in addition to BPF 140. Alternatively, BPF 140 may be placed after a power amplifier 150.

To compensate the conversion losses due to the mixer 130 and filter 140, the power amplifier 150 may generate a signal level that is required to feed an integrated frequency multiplier 160. Power amplifier 150 may be an off the shelf component such as the model CHA2094b 36-40GHz Low Noise High Gain Amplifier from UMS. In this example, the frequency multiplier 160 may be a frequency doubler. The frequency multiplier may be configured in chip form, such as the model CHU3277 W-band Multi-function Multiplier from UMS.. The CHU3277 is a W-band monolithic multifunction, which integrates an input buffer/power divider and two W-band chains in parallel combined at the output. Each chain includes a frequency multiplier and a 4-stage medium power amplifier, so as to provide the transmit power for the modulated carrier.

The signal output from frequency multiplier 160 is a modulated carrier which may be fed directly to a suitable antenna or horn 170 for transmission, at a carrier frequency of 76.5 GHz at a exemplary transmit power of 18 dBm, for example. The antenna 170 may be any flat, conformal or shaped antenna capable of transmitting the modulated carrier over the link distance in a means consistent with FCC emissions regulations. Such antennas may include circular horns, prime focus and offset parabolic dishes and planar slot arrays, for example. One antenna may be employed for both transmit and receive operations, or a plurality of antennas may be used for providing spatial diversity in a single transceiver, for example.

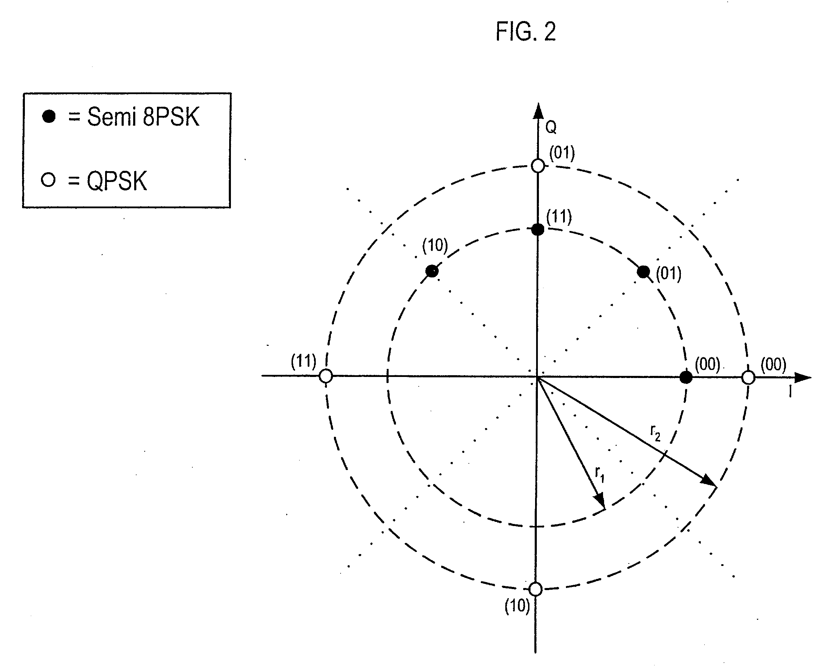

FIG. 2 is a phase diagram for illustrating a method of modulating an input signal to obtain a desired intermediate signal that may be subject to a frequency multiplier operation within the transmitter circuit of FIG. 1. FIG. 2 is designed to illustrate how severe signal distortion that is typically caused by use of a frequency multiplier may be reduced or avoided in accordance with the exemplary embodiments of the present invention.

Digital processor 105 may generate a set of signal states applicable to the desired modulated baseband signal 125. For example, digital processor 105 may be used to map digital signal states of a given (first) modulation scheme onto part of the available signal states of a next (second) higher modulation scheme, prior to sending the signals as I and Q baseband signal inputs to the I/Q modulators 115a/115b. A consideration underlying this is that the effects of the frequency multiplier 160 on signal phase states are taken into account, in order to obtain the desired modulated baseband signal 125 (desired intermediate signal). In other words, digital processor 105 may iterate a relatively simple scheme or algorithm to determine the different phase states (occasionally also referred to hereafter as signal states) that need to be excited so as to generate a proper set of signal states for the desired modulated baseband signal 125.

The frequency multiplier 160, which subjects the amplified IF signal to a frequency multiplier operation, is characterized by an 'ambiguous' transfer function. Accordingly, modulation should be performed such that the modulated carrier output of the frequency multiplier 160 has a substantially non-ambiguous relation to the desired modulated baseband signal. This will be explained further below, after the following discussion to explain transfer functions in general and the ambiguous transfer function characteristic exhibited by the frequency multiplier 160.

In general, a transfer function is a mathematical statement that describes the transfer characteristics of a system, subsystem, or equipment. A transfer function may be characterized as a relationship between the input and the output of a system, subsystem, or equipment in terms of the transfer characteristics. When the transfer function operates on the input, the output is obtained. Given any two of these three entities, the third can be obtained. Examples of simple transfer functions are voltage gains, reflection coefficients, transmission coefficients, and efficiency ratios. An example of a complex transfer function is envelope delay distortion.

In frequency multipliers such as frequency multiplier 160, signals input thereto are applied to nonlinear or 'ambiguous' transfer functions. Such a nonlinear transfer function may be expressed by a Fourier expansion y' = a + b*y + c*y² + d*y³ + ... , wherein a, b, c, d,... are Fourier coefficients. The input signal amplitude determines the weights of these coefficients. For example, a frequency multiplier 160 such the aforementioned frequency doubler chip may have a quadratic characteristic y' = c*y². As an input sinusoidal signal y = sin(2πft) with frequency f and phase p is applied to the transfer function of the doubler chip, the resulting output signal will be y'=c*sin²(2πft + p) = 1/2*c*(1-cos (2πft · 2ft) + 2p)) Apart from the constant part, which is usually filtered out by a high pass filter such as filter 140, the remaining sinusoidal signal of doubled frequency is of interest. The input signal herein is of course the modulated baseband signal 125, after being subject to the aforementioned upconverting, filtering and amplifying processes) In addition to the frequency being doubled by this operation, the phase angle of the input signal is doubled, which in itself is an ambiguous operation due to the phase limitation (0-360°). The transfer function of the frequency multiplier 160 is thus ambiguous because the information of whether p or p+180° was subject to the transfer function becomes lost in the operation performed by the doubler chip.

Thus, since the frequency multiplier 160 is a nonlinear device in the transmitter circuit 100, the application of conventional modulation schemes is substantially limited. Only an amplitude shift keying modulation can conceivably pass without being subject to severe signal distortion. For other modulation schemes like Quadrature Phase Shift Keying (QPSK), 8-ary Phase Shift Keying (8PSK) or X-Quadrature Amplitude Modulation (X-QAM), where X may be 64,128, etc., depending on noise level, which may be desirable modulation schemes for digital wireless transmission links, the use of a frequency multiplier 160 (such as a frequency doubler) in the transmit chain leads to non-recoverable distortions of the signal states.

However, the inventors have found that this problem may be solved by pre-mapping the digital signal states of one modulation scheme onto half of the available signal states of the next higher modulation scheme. This may be described with reference to FIG. 2, which illustrates such a mapping technique for QPSK modulation.

Referring now to FIG. 2, each dot represents a data point of digital data to be transmitted. For example, each dot represents two digital bits (i.e., 11). In FIG. 2, the solid dots represent signal states for digital data of an input baseband signal (i.e., modulated baseband signal 125 after the aforementioned upconverting, filtering and amplifying processes) and the hollow dots represent available signal states for the digital data after passing the frequency multiplier 160 (i.e., the modulated carrier). Depending on the digital word to be sent (i.e., what bits should be sent), the desired modulated baseband signal 125 assumes the phase states of 0 degrees, 45 degrees, 90 degrees, or 135 degrees, as shown in FIG. 2. These phase states remain unchanged until the signal reaches the frequency multiplier 160. In this example, the multiplier 160 is configured as a frequency doubler.

Because the doubler has a quadratic characteristic, all phase values are doubled in the up-conversion process to double frequency and are therefore projected on conventional QPSK phase states (see hollow dots). Accordingly, a desired signal for transmission can therefore be recovered with conventional QPSK receiver architectures. In other words, the mapping as shown in FIG. 2 enables the modulated carrier that is output of the frequency multiplier 160 to be transmitted via antenna 170 at the carrier frequency to have a substantially non-ambiguous relation to the input baseband signal, and hence the desired modulated baseband signal 125, therefore overcoming the problems with severe distortion that would occur by using conventional modulation schemes.

This mapping (pre-mapping) feature for QPSK may also work for higher order modulation schemes. For example, an m-PSK modulation may be generated by providing the first half of the 2m-PSK signal states. Moreover, X-QAM modulation schemes may be conceivable if the amplitude states are also pre-mapped according to the input signal level dependent Fourier coefficient (e.g. c = f(y)) for the desired harmonic. This can be done by estimating or measuring the dependency c = f(y), for example.

Accordingly, a multifunctional transceiver, such as the aforementioned W-band transceiver, may be configured so as to include the transmitter circuit 100. The transmitter circuit 100 is adapted for modulating an input signal as described in the exemplary modulation method described above, so as to provide a wireless link in one or more of the 71-76 GHz, 81-86 GHz and 92-95 GHz bands.

The methods of modulation and transmission described herein may offer several advantages over available modulation schemes that are used in conjunction with frequency multipliers. Compared to an ASK modulation scheme, a 2PSK modulation scheme offers a 3dB increased signal to noise ratio. Higher modulation schemes offer higher spectral efficiency, which means that more information can be transmitted within the same spectral bandwidth

The methods and circuit structure described herein may enable the realization of a cost competitive wireless link solution to T1/E1, providing wireless link performance at 75 GHZ and greater in the E-band, at bandwidths of 1.25 Gbps full duplex and ranges of a least 2 miles, depending on weather conditions.

The exemplary embodiments of the present invention being thus described, it will be obvious that the same may be varied in many ways. Such variations are not to be regarded as departure from the spirit and scope of the exemplary embodiments of the present invention, and all such modifications as would be obvious to one skilled in the art are intended to be included within the scope of the following claims.

## Claims

1. A method of modulating an input signal to obtain a desired intermediate signal that is to be subject to processing for transmission over a wireless link at a carrier frequency within a desired frequency band, the processing including subjecting the desired intermediate signal to a frequency multiplier operation that exhibits an ambiguous transfer function, the method comprising:
providing an input signal for modulation;
generating a set of signal states applicable to the desired intermediate signal so that a carrier signal resulting from the processing has a substantially non-ambiguous relation to the desired intermediate signal; and
modulating the input signal according to I and Q baseband signals to obtain the desired intermediate signal with the generated set of signal states.

2. A method of transmitting data over a wireless link at a carrier frequency within a desired frequency band, comprising:
inputting a sinusoidal signal for modulation;
generating a set of signal states applicable to a desired modulated baseband signal;
modulating the sinusoidal signal according to I and Q baseband signals to obtain the desired modulated baseband signal with the generated set of signal states;
forming an input signal based on the desired modulated baseband signal;
subjecting the input signal to a frequency multiplier operation **characterized by** an ambiguous transfer function, so as to produce an output signal at the carrier frequency that has a substantially non-ambiguous relation to the input signal; and
transmitting the output signal at the carrier frequency within the desired frequency band over the wireless link.

3. The method of claims 1 or 2, wherein the desired frequency band encompasses a spectrum of frequencies in the 71-76 GHz, 81-86 GHz and 92-95 GHz bands.

4. The method of claims 1 or 2, wherein the step of generating includes mapping signal states of a first modulation scheme onto at least a portion of states of a plurality of available signal states for a second, higher-order modulation scheme to provide I and Q modulation signal inputs to the modulating step.

5. The method of claims 1 or 2, wherein modulating further includes modulating the input signal in quadrature.

6. The method of claims 1 or 2, wherein modulating includes modulating the input signal in phase and amplitude.

7. The method of claim 1, wherein the signal to be transmitted has a substantially non-ambiguous relation to the desired intermediate signal as evident by signal states of the signal to be transmitted, which is output from the frequency multiplier, substantially corresponding to signal states of the desired intermediate signal, which is input to the frequency multiplier.

8. The method of claim 2, wherein the output signal has a substantially non-ambiguous relation to the desired modulated baseband signal, as evident by signal states of the signal output from the frequency multiplier substantially corresponding to signal states of the input signal input to the frequency multiplier.

9. The method of claim 2, wherein the step of forming includes:
upconverting the modulated baseband signal to an intermediate frequency (IF) signal;
filtering the IF signal to remove out-of-band components;
amplifying the filtered IF signal to a desired signal level to provide the input signal.

10. A transmitter circuit (100) for transmitting data over a wireless link at a carrier frequency within a desired frequency band, comprising:
at least one frequency synthesizer (110a) for inputting a sinusoidal signal for modulation;
a digital processor (105) for generating a set of signal states applicable to a desired modulated baseband signal;
at least one modulator (115a) for modulating the sinusoidal signal according to I and Q baseband signals to obtain the desired modulated baseband signal(125) with the generated set of signal states;
a mixer (130) for upconverting the modulated baseband signal to an intermediate frequency (IF) signal (132);
a filter (140) for filtering the IF signal to remove out-of-band components;
an amplifier (150) for amplifying the filtered IF signal to a desired signal level to provide an input signal,
a frequency multiplier (160) for subjecting the input signal to a frequency multiplier operation **characterized by** an ambiguous transfer function, so as to produce an output signal at the carrier frequency that has a substantially non-ambiguous relation to the input signal; and
an antenna (170) for transmitting the output signal at the carrier frequency within the desired frequency band over the wireless link.
